# EUROPÄISCHE PATENTSCHRIFT

(11) **EP 1 943 733 B1**
(45) Veröffentlichungstag und Bekanntmachung des Hinweises auf die Patenterteilung: **01.09.2010**
(21) Anmeldenummer: 06819111.3
(22) Anmeldetag: 20.10.2006
(51) Int. Cl.: H03K 17/12, H03K 17/082

(54) **TEMPERATURKOMPENSATION BEI ENDSTUFEN**
TEMPERATURE COMPENSATION IN OUTPUT STAGES
SYSTEME DE COMPENSATION THERMIQUE DANS DES ETAGES DE SORTIE

(30) Priorität: 25.10.2005 DE 102005051004
(43) Veröffentlichungstag der Anmeldung: 16.07.2008
(73) Patentinhaber: ROBERT BOSCH GMBH, 70442 Stuttgart (DE)
(72) Erfinder: ECKHARDT, Juergen, 71706 Markgroeningen (DE); NOTTEBOM, Bernd, 71726 Benningen (DE); TEPASS, Bernd, 71717 Beilstein (DE)
(86) Internationale Anmeldenummer: PCT/EP2006/067630
(87) Internationale Veröffentlichungsnummer: WO 2007/048761

(56) Entgegenhaltungen:
- EP-A- 0 881 682
- DE-C1- 10 157 250
- US-A- 4 196 361
- US-A- 5 909 108

## Beschreibung

Die Erfindung betrifft eine Temperaturkompensation, insbesondere eine Temperaturkompensation der Klammerphase bei Endstufen bzw. Schalt-Endstufen zum Schalten induktiver Lasten mit wenigstens zwei parallel geschalteten Einzelendstufen gemäß dem Oberbegriff des Patentanspruchs 1.

### Stand der Technik

Moderne Fahrzeuge sind mit einer Vielzahl von Relais, Ventilen und anderen Bauelementen ausgestattet, die bezüglich ihrer elektrischen Eigenschaften ohmsch-induktive Lasten darstellen. Zum Schalten dieser Elemente sind so genannte Schalt-Endstufen vorgesehen, deren Transistoren je nach zu schaltender Leistung unterschiedlich groß ausgelegt sind. Die Transistoren sind in Spannungsgegenkopplung, also als Dioden geschaltet, wobei im Gegenkopplungspfad ein Bauelement angeschlossen ist, das die Zenerspannung der Transistoren bestimmt. Beim Abschalten der induktiven Last wirken die Transistoren als Zenerdioden, die den Abschaltstrom ableiten.

Zur Erhöhung der Schaltleistung können Schalt-Endstufen prinzipiell beliebig parallel geschaltet werden. Der zulässige Schaltstrom ergibt sich dann aus der Summe der Einzel-Schaltströme der parallel geschalteten Schalt-Endstufen. Beim Abschalten erhöht sich die Abschaltenergie bzw. die Abschaltleistung jedoch nicht entsprechend der erwarteten Werte auf Grund der Parallelschaltung. Es wird also nicht die Summe der EinzelAbschaltenergien der parallel geschalteten Einzel-Endstufen erhalten.

Dies gilt in besonders extremer Weise für eine Parallelschaltung von Schalt-Endstufen bzw. Endstufen mit unterschiedlicher Schaltleistung oder unterschiedlicher Zenerspannung, die beispielsweise auch toleranzbedingt auftreten kann. Bei solchen Parallelschaltungen kann zwar der zulässige Schaltstrom bzw. die zulässige Schaltleistung gesteigert werden, jedoch nicht die zulässige Abschaltleistung bzw. Abschaltenergie. Vielmehr liegt die zulässige Abschaltenergie nur in der Größenordnung der schwächsten Endstufe. Durch diese Tatsache wird der Einsatzbereich der Endstufen stark eingeschränkt und es werden heute zum Schalten von ohmsch-induktiven Lasten nur Endstufen bzw. Endstufentransistoren gleicher Leistungsklasse parallel geschaltet.

Aber selbst bei der Parallelschaltung von Endstufen gleicher Leistungsklasse können toleranzbedingte Probleme auftreten, denn heute eingesetzte Endstufen bzw. Endstufenbausteine haben auf einem monolithischen integrierten Endstufen-Chip fertigungsbedingte Toleranzen in der Zenerspannung von +/- 1.5 Volt bei gleich spezifiziertem Zenerspannungswert.

US 5 909 108 offenbart eine Endstufe umfassend mehrere parallel geschaltete Einzel-Endstufen mit wenigstens einer Komponente und einem Transistor wobei die Komponente im oder nahe am Schalttransistor angeordnet sind, so dass sie thermisch mit dem Transistor gekoppelt ist.

Die noch nicht offen gelegte Patentanmeldung DE 102005019709.4 beschreibt Möglichkeiten um die Belastung einzelner Transistoren bei parallel geschalteten Einzel-Endstufen bzw. Einzel-Schalt-Endstufen bei einem Abschaltvorgang zu reduzieren und eine möglichst gleichmäßige Stromverteilung auf alle Transistoren der Einzel-Endstufen zu bewirken und so zu erreichen, dass die Summe der Abschaltenergie im Wesentlichen der Summe der Einzelabschaltenergien entspricht.

Die beschriebene Endstufe bzw. Schalt-Endstufe zum Schalten induktiver Lasten mit wenigstens zwei parallel geschalteten Einzel-Endstufen ermöglicht, dass beliebige Einzel-Endstufen, auch aus unterschiedlichen Leistungsklassen parallel geschaltet werden können, ohne dass die Einschränkung einer verminderten Abschaltenergie hinzunehmen ist. Erzielt wird dies, indem ein Symmetrieren der Endstufen-Zenerspannung erfolgt. Dabei muss beim Symmetrieren die Zenerspannung unter Last und/oder Temperatur höher werden, d.h. einen positiven Last- und/oder Temperaturkoeffizienten aufweisen. In einem solchen Fall steigt die Zenerspannung so hoch, dass sie die die Höhe der Zenerspannung der parallel geschalteten Endstufe erreicht und somit diese Einzel-Endstufe ebenfalls Abschaltenergie übernehmen wird.

In besonderer Ausgestaltung kann die ohnehin vorhandene Zenerdiode oder auch eine vorhandene Zenerkaskade ausgenutzt werden und diese in die Endstufenfläche des Chips integriert werden. Da die in Endstufen eingesetzten Zenerdioden mit den benötigten Zenerspannungen üblicher Weise ohnehin einen positiven Temperatureffekt aufweisen, erhöht sich die Zenerspannung automatisch bei heißer werdendem Transistor. Dies wird durch entsprechende räumliche Zuordnung von Zenerdiode und Transistor bzw. Schalttransistor ausgenutzt.

Ein wesentlicher Aspekt der in der Patentanmeldung DE 102005019709.4 beschriebenen Lösung besteht darin, die im Gegenkopplungspfad der Schalttransistoren vorhandenen Bauelemente, z. B. Zenerdioden in oder nahe der Halbleiter-Struktur der Schalttransistoren anzuordnen, so dass sie thermisch an die Transistoren gekoppelt sind. Dies hat folgenden Effekt: Wenn durch einen der Transistoren ein hoher Strom fließt, wird dieser heiß und erwärmt dadurch auch die Zenerdiode. Bei Bauelementen mit positivem Temperaturkoeffizient, d.h. der Widerstand bzw. bei Zenerdioden die Durchbruchschwelle steigt mit zunehmender Temperatur, steigt dadurch ebenfalls die Zenerspannung der Endstufe. Wenn die Zenerspannung das Niveau einer anderen Endstufe, die noch nicht in den Zenerbetrieb übergegangen ist, erreicht, kann die andere Endsstufe somit ebenfalls Abschaltenergie übernehmen, wodurch diese wiederum heiß wird, usw.. Durch die thermische Kopplung der Zenerdioden an die Schalttransistoren ist es daher möglich, die Zenerspannungen der einzelnen Transistorstufen schnell aneinander anzugleichen und somit die Abschaltenergie gleichmäßig auf alle Transistoren der Schalt-Endstufe zu verteilen, ohne einzelne Transistoren zu überlasten.

Bei den im Gegenkopplungspfad angeordneten Bauelementen oder ohnehin vorhandenen Komponenten handelt es sich beispielsweise um Zenerdioden oder thermische Widerstände. Vorzugsweise werden Bauelemente mit einem sehr hohen Temperaturkoeffizienten, insbesondere einem exponentiellen Temperaturkoeffizienten gewählt. Dadurch gleichen sich die Zenerspannungen besonders schnell aneinander an.

In besonderer Weise kann die beanspruchte Lösung auf eine Parallelschaltung einer Vielzahl von Einzel-Endstufen ausdehnen, wobei dann ein Transistor nach dem anderen bzw. eine Endstufe nach der anderen aufgrund der durch Erwärmung steigenden Zenerspannung Abschaltenergie übernimmt.

### Offenbarung der Erfindung

Ausgehend von der vorstehend beschriebenen Lösung besteht die Aufgabe der Erfindung darin, eine Verteilung der Energie in der Klammerphase bzw. der Abschaltenergie in der Abschaltphase gleichmäßig auf alle parallel geschalteten Endstufen bei starker Temperaturabhängigkeit der Klammerspannung zu ermöglichen. Dies ist mit einer Drift der Klammerspannung über die Umgebungstemperatur verbunden, die es zu verringern gilt.

Gelöst wird diese Aufgabe gemäß der Erfindung durch die im Patentanspruch 1 angegebenen Merkmale. Dazu wird einzusätzliches Bauteil, beispielsweise eine Diode, insbesondere eine Zenerdiode oder NTC-Widerstand in Reihe mit den Zenerdioden der Endstufe geschaltet, mit speziellem Temperaturverhalten. Das zusätzliche Bauteil wird auf dem Chip, beispielsweise einem Siliziumchip entfernt von den Zenerdioden angeordnet, wodurch eine Kompensation der Drift der Klammerspannung über die Umgebungstemperatur ermöglicht wird.

Weitere Vorteile der Erfindung werden durch die in den Unteransprüchen angegebenen Maßnahmen erzielt. Dabei ist besonders vorteilhaft, dass zwei voneinander unabhängige Temperaturkompensationen durchgeführt werden können. Durch die unterschiedlichen Temperaturkompensationen kann in vorteilhafter Weise auf langsame umgebungsbedingte und schnelle klammerungsbedingte Anforderungen unterschiedlich reagiert werden, wodurch eine optimale Kompensation der Temperatureffekte möglich wird und damit eine gleichmäßige Verteilung der Energie in der Klammerphase auf die parallel geschalteten Endstufen erhalten wird.

Die Erfindung wird nachstehend anhand der beigefügten Figuren der Zeichnung beispielhaft näher erläutert. Es zeigen:
Fig. 1 ein Endstufenprinzipschaltbild bei Parallelschaltung zweier Endstufen;
Fig. 2 eine Endstufe bzw. Schalt-Endstufe bei Parallelschaltung zweier Endstufen gemäß einer Ausführungsform der DE 102005019709.4,
Fig. 3 den Strom- und Spannungsverlauf an den Transistoren der Endstufenschaltung nach Fig. 2,
Fig. 4 einen Ausschnitt eines Halbleiterchips mit einer erfindungsgemäßen Endstufe bzw. Schalt-Endstufe,
Fig. 5 eine Endstufe bzw. Schalt-Endstufe bei Parallelschaltung zweier Endstufen gemäß einer Ausführungsform der Erfindung.
Fig. 6 einen Ausschnitt eines Halbleiterchips mit einer erfindungsgemäßen Endstufe bzw. Schalt-Endstufe,
Fig. 7 den Strom- und Spannungsverlauf an den Transistoren der Endstufenschaltung nach Fig. 5,

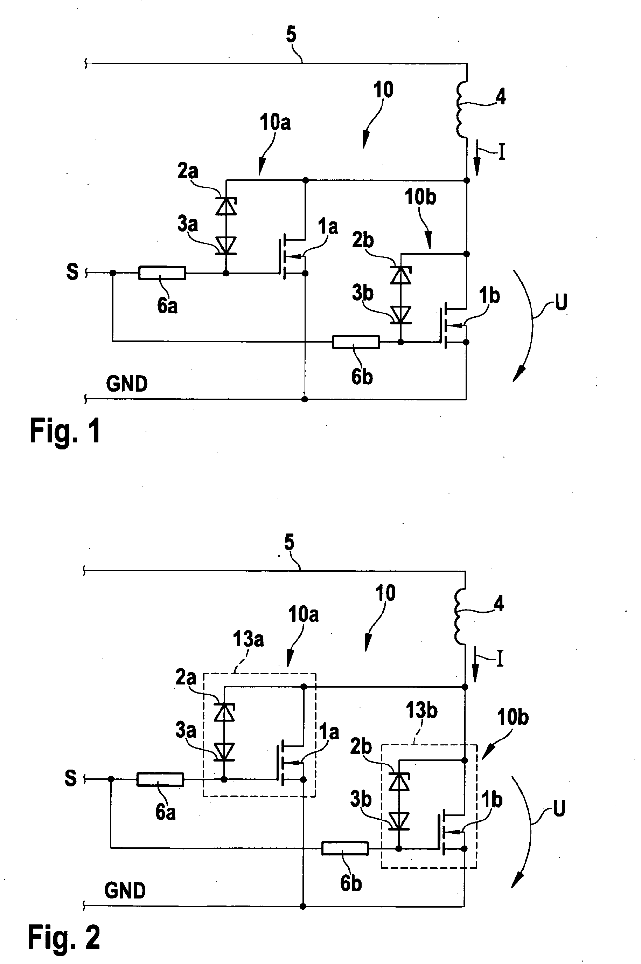

Fig. 1 zeigt beispielhaft ein Endstufenprinzipschaltbild bei Parallelschaltung zweier Einzel-Endstuferi, die insbesondere als IC realisiert ist. Jede der beiden Einzel-Endstufen umfasst einen Schalttransistor und eine zugehörige Diodenanordnung. Die Parallelschaltung 10 der zwei Einzel-Endstufen 10a, 10b umfasst dabei die parallel geschalteten Transistoren 1a und 1b. Im Gegenkopplungspfad der Transistoren 1a bzw. 1b ist eine Diodenanordnung 2a, 3a bzw. 2b, 3b vorhanden, die zwischen den Steueranschluß (Gate) und einen Leistungsanschluß (Drain) des Transistors 1a bzw. 1b liegt. Die Diodenanordnung 2a ,3a bzw. 2b, 3b umfasst jeweils eine in Sperrichtung geschaltete Zenerdiode 2a, 2b und eine in Flussrichtung geschaltete Diode 3a bzw. 3b.

Die Transistoren 1a, 1b werden von einem nicht dargestellten Steuergerät mittels eines Steuersignals S angesteuert, um die ohmsch-induktive Last 4 zu schalten. Die Zuführung des Signales S erfolgt über die Widerstände 6a bzw. 6b. Im eingeschalteten Zustand verteilt sich der durch die Last 4 fließende Strom I widerstandsabhängig auf die Transistoren 1a, 1b der Einzel-Endstufen 10a bzw. 10b.

Beim Abschalten der ohmsch-induktiven Last 4 muss die gespeicherte magnetische Energie der Last abgebaut werden kommt es an den Transistoren 1a, 1b zu hohen Spannungen, wodurch die Zenerdioden 2a, 2b in Sperrichtung durchbrechen. Die Transistoren 1a, 1b gehen dabei in den Zenerbetrieb über, d.h. sie wirken selbst als Zenerdioden und leiten den Strom gegen Masse GND ab, wobei die gesamte elektrische Leistung in den Transistoren 1a, 1b in Wärme umgesetzt wird.

Die Zenerdioden 2a, 2b einer Parallelschaltung 10 zweier (Schalt)-Endstufen sind üblicherweise identisch ausgelegt. Aufgrund von Diffusionsunterschieden, Materialunterschieden, Temperaturdriften, etc. können die Zenerspannungen der Zenerdioden 2a, 2b aber erheblich voneinander abweichen. In den Abschaltphasen bricht dann diejenige Zenerdiode 2a bzw. 2b mit der geringsten Zenerspannung zuerst durch. Dies führt zu einer erheblichen Belastung des zugehörigen Transistors 1a bzw. 1b, der zumindest kurzfristig die gesamte elektrische Leistung, aufnehmen muss, bis der nächste Transistor in den Zenerbetrieb übergeht. Der erste Transistor 1a bzw. 1b kann dadurch geschädigt oder zerstört werden.

Fig. 2 zeigt eine Parallelschaltung 10 zweier (Schalt)-Endstüfen, die im wesentlichen identisch aufgebaut ist wie im Beispiel nach Fig. 1. Bezüglich der Erläuterung der identischen Elemente wird auf die Beschreibung der Figur 1 verwiesen. Im Unterschied zur Schaltung nach Fig. 1 sind die Zenerdioden 2a bzw. 2b hier thermisch an die zugehörigen Schalttransistoren 1a bzw. 1b, beispielsweise MOSFETs gekoppelt. Die thermische Kopplung ist dabei durch gestrichelte Bereiche 13a bzw. 13b angedeutet.

Beim Abschalten der induktiven bzw. ohmsch-induktiven Last 4, also wenn das Steuersignal S auf low schaltet, muss die gespeicherte magnetische Energie bzw. die Abschaltenergie der Last abgebaut werden. Dazu wird der verwendete Schalttransistor der Endstufe als Zenerelemet benutzt. Bei mehreren parallel geschalteten Endstufen geht dabei die Endstufe mit der geringeren Zenerspannung, z.B. die Endstufe mit dem Schalttransistor 1a, und den Dioden 2a und 3a zuerst in den Zenerbetrieb über. Der andere Transistor 1b befindet sich dann noch im Sperrzustand, so dass der Transistor 1 a kurzfristig die gesamte Verlustleistung bzw. Abschaltenergie aufnehmen muss. Aufgrund der thermischen Kopplung von Zenerdiode 2a und Schalttransistor 1a heizt sich die Zenerdiode 2a sehr schnell auf, wobei deren Zenerspannung steigt. Dadurch steigt die Zenerspannung der ersten Transistorstufe 1a, 2a, 3a. Wenn die Zenerspannung der zweiten Transistorstufe 1b, 2b, 3b erreicht ist, übernimmt diese einen Teil der Abschaltenergie. Da die Angleichung der Zenerspannungen der Transistorstufen relativ schnell geschieht, wird die zuerst durchbrechende Transistorstufe nicht überlastet und es findet eine Symmetrierung der Zenerspannung statt.

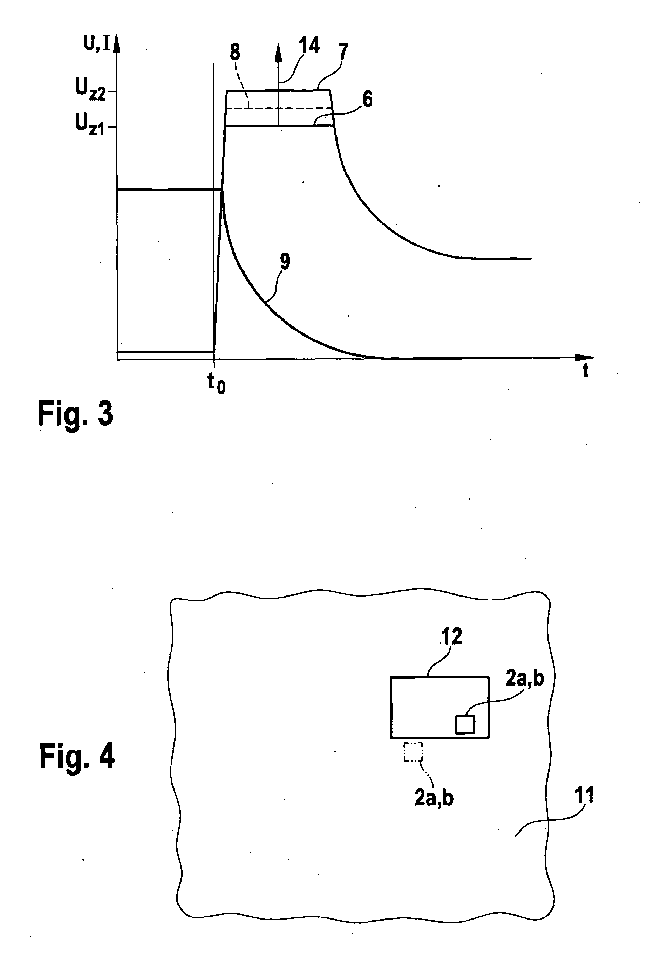

Fig. 3 zeigt den Strom- und Spannungsverlauf an Transistoren 1a bzw. 1b mit unterschiedlicher Zenerspannung (Drain-Gate-Spannung) während eines Abschaltvorgangs. Dabei bezeichnet das Bezugszeichen 9 den Stromverlauf I und die Bezugszeichen 6 und 7 die Spannungsverläufe an den zwei parallel geschalteten Transistoren 1 a bzw. 1b mit unterschiedlicher Zenerspannung U_{z2a} und U_{z2b} Im vorliegenden Beispiel wird die induktive Last 4 zum Zeitpunkt t₀ abgeschaltet, wodurch der Strom I exponentiell gegen Null sinkt. Die Spannung U steigt sprungartig an, bis die Zenerspannung U_{z1a} erreicht ist, und die Zenerdiode (in diesem Beispiel mit U_{z2a}<U_{z2b} also die Zenerdiode 2a) durchbricht.

Die zugehörige Endstufe leitet dann den Strom I gegen Masse GND ab. Dabei erwärmt sich der Transistor 1a und damit auch die Zenerdiode 2a, wodurch deren Zenerspannung U_{z2a} steigt. Die Zunahme der Zenerspannung mit steigendender Temperatur wird durch die Richtung des Pfeils 14 dargestellt. Die höhere Zenerspannung U_{z2a} ist dabei durch eine gestrichelte Linie 8 angedeutet. Erreicht die Zenerspannung U_{z2a} den Wert U_{z2a} kann die zweite parallel geschaltete Endstufe, deren Temperatur dann noch nicht erhöht ist, ebenfalls Abschaltenergie übernehmen. da ihre Zenerspannung, die bei nicht erhöhter Temperatur vorliegt, erreicht wird..

Diese Vorgehensweise, die einem Symmetrieren der Endstufen-Zenerspannung entspricht, ist dann möglich, wenn die Zenerspannung unter Last und/oder Temperatur höher wird, also einen positiven Last- und/oder Temperaturkoeffizienten aufweist. Damit kann eine positive Zenerspannungsausprägung bei Parallelschaltung mehrerer Endstufen erzielt werden.

Fig. 4 zeigt eine Aufsicht auf einen flächigen Halbleiterchip 11, z.B. aus Silizium, mit einer Transistor-Struktur, die hier schematisch als ein Bereich 12 dargestellt ist und beispielsweise dem Schalttransistor 1a der Endstufe 10a entspricht. Die zugehörige, ohnehin vorhandene Zenerdiode 2a kann innerhalb dieses Bereichs oder nahe des Bereichs 12 angeordnet sein und insbesondere in die Endstufenfläche integriert sein und ist damit thermisch möglichst gut an den Schalttransistor Transistor gekoppelt. Die vorhandene elektrische Verbindung zwischen einzelnen Schaltungsbestandteilen entsprechend Figur 2 ist in Figur 4 nicht dargestellt.

Falls die Zenerdiode 2a eine niedrige Zenerspannung U_{z} hat, wird sich der zugehörige Transistor 1a bei einem Abschaltvorgang relativ schnell erwärmen, da er einen Großteil der abzubauenden elektrischen Leistung als Abschaltstrom führt und in Wärme umsetzt.

Dabei erwärmt sich die Zenerdiode 2a in gleichem Maße, wodurch die Zenerspannung U_{z} ansteigt. Sobald sich die Zenerspannung U_{z2a} auf gleichem Niveau wie die Zenerspannung U_{z2b} befindet, übernimmt auch der andere Schalttransistor 1b (nicht gezeigt) einen Teil der abzubauenden elektrischen Energie. Die gesamte elektrische Leistung bzw. elektrische Energie, die beim Abschalten einer ohmsch-induktiven Last zu bewältigen ist, kann somit auf mehrere parallel geschaltete Transistoren 1a, 1b bzw. mehrere parallel geschaltete Endstufen gleichmäßig verteilt werden.

Anstelle der Zenerdioden 2a bzw. 2b kann beispielsweise auch ein thermischer Widerstand mit positivem Temperaturkoeffizienten oder eine sonstige geeignete Komponente mit positivem Temperaturkoeffizient eineingesetzt werden.

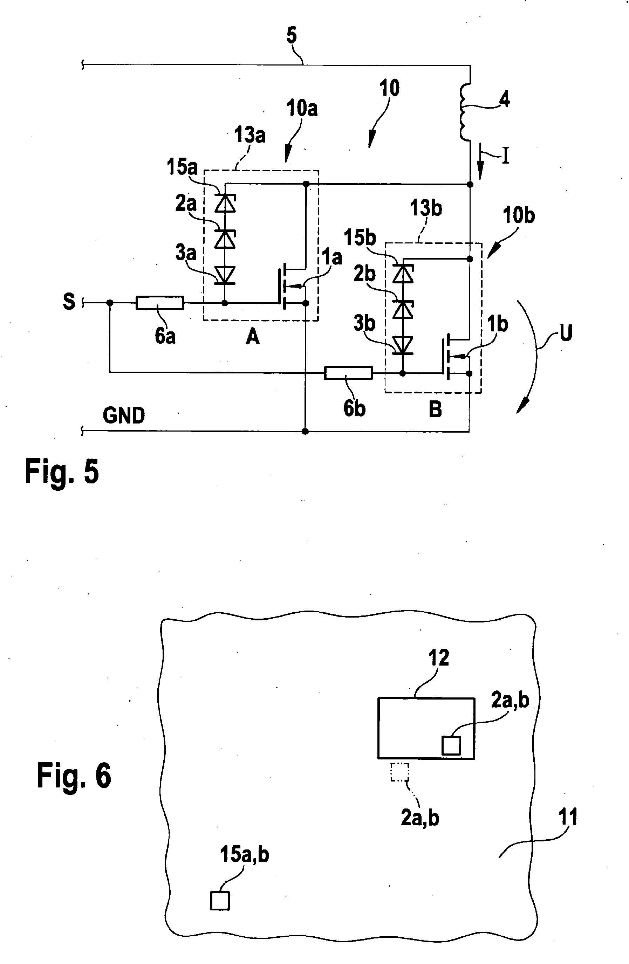

Ein Ausführungsbeispiel der Erfindung ist in Figur 5 für zwei Einzel-Endstufen A und B dargestellt. Es unterscheidet sich vom Beispiel nach Figur 2 durch wenigstens eine zusätzliche Diode 15a, 15b, die schaltungstechnisch in Reihe zu den Dioden 2 und 3 liegt. Mechanisch betrachtet ist sie auf dem Chip jedoch so weit von den Dioden 2 und 3 entfernt, dass die thermische Kopplung mit der Endstufe vernachlässigbar ist und für die Temperatur der Diode praktisch nur die Umgebungstemperatur relevant ist. Die Diode kann als Zenerdiode ausgestaltet sein oder durch einen NTC-Widerstand ersetzt sein.

Für das Ausführungsbeispiel nach Figur 5 gilt: Die individuelle Rückkopplung mit positivem Temperaturkoeffizient über die Zenerdioden 2a, 2b zur Begrenzung der Klammerspannung der Endstufen bleibt wie beim Ausführungsbeispiel nach Figur 2 erhalten. Die Zenerdioden 2a, 2b liegen dabei unverändert mit guter, also schneller thermischer Ankopplung innerhalb des Endstufentransistors oder unmittelbar neben dem Endstufentransistor.

An anderer Stelle auf dem Chip bzw. dem Silizium des Endstufenbausteins, thermisch unabhängig von den kurzzeitigen Temperaturspitzen, die während der Klammerphase auftreten, ist als zusätzliches Bauteil mit negativem Temperaturkoeffizient wenigstens eine Diode 15a, 15b, beispielsweise als Zenerdiode oder als NTC-Widerstand ausgestaltet platziert. Damit kann ein Driften der Klammerspannung aller Endstufen über eine allgemeine Temperaturänderung des Bauteils kompensiert werden. Auch eine Überkompensation ist möglich. Dargestellt ist ein solcher erfindungsgemäßer Chip in Figur 6. Die vorhandene elektrische Verbindung zwischen einzelnen Schaltungsbestandteilen entsprechend Figur 5 ist in Figur 6 nicht dargestellt.

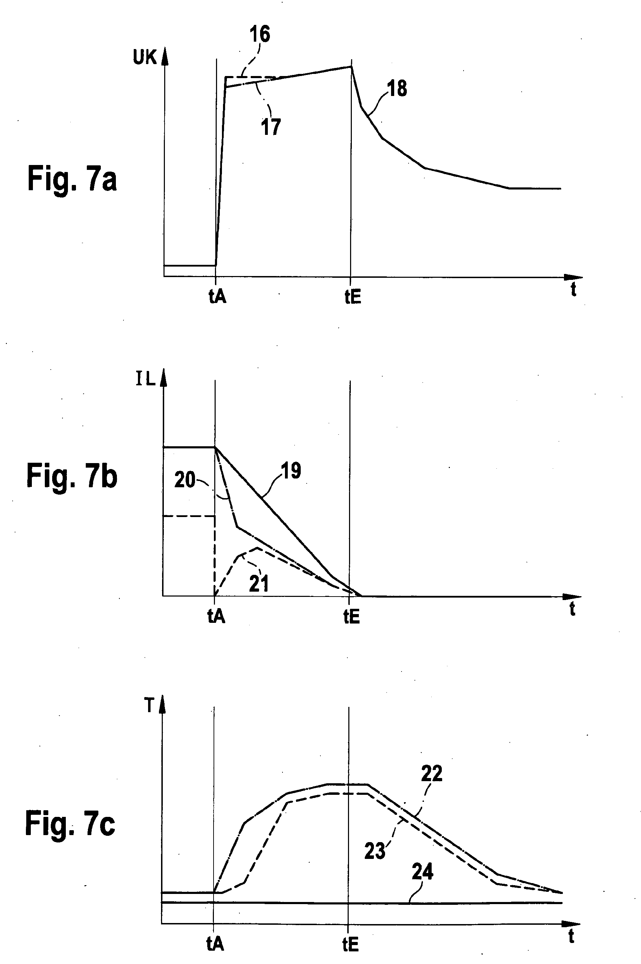

Den Verlauf einer Klammerung bei parallel geschalteten Endstufen A und B mit Symmetrierung und der vorstehend beschriebenen Temperaturkompensation zeigen für ein vorgegebenes Beispiel die Figur 7a, 7b und 7c. Beispielhaft ist die toleranzbedingt mit geringerer Zenerspannung klammernde Endstufe die Endstufe A. Aufgetragen ist in Figur 7a die Klammerspannung UK über der Zeit t. Mit 16 ist die Klammerspannung der Endstufe B, mit 17 die der Endstufe A und mit 18 der Verlauf der Klammerspannung bei Parallelschaltung bezeichnet. In Figur 7b ist der Laststrom IL und in Figur 7c die Temperatur T über der Zeit t aufgetragen. Die Laststrom Summe 19 setzt sich dabei zusammen aus den beiden Lastströmen 20 und 21 der Endstufen A und B. Der Temperaturverlauf der beiden Endstufen ist mit 22 und 23 bezeichnet. 24 stellt die Temperatur des Chips dar. Der Abschaltzeitpunkt ist mit tA und das Ende der Klammerphase mit tE bezeichnet.

Die im gezeigten Beispiel toleranzbedingt mit geringerer Zenerspannung klammernde Endstufe A übernimmt zunächst den gesamten Strom, der durch die ohmsch-induktive Last 4 nach dem Abschalten weiter getrieben wird. Durch die dabei in der Endstufe A entstehende Leistung wird die Endstufe A aufgeheizt und deren Klammerspannung erhöht sich infolge der Rückkopplung mit positivem Temperaturkoeffizient. Erreicht die Klammerspannung der Endstufe A infolge steigender Temperatur einen Wert, der der Zenerspannung der Endstufe B bei der dann an der Endstufe B noch herrschenden niederen Temperatur wird auch Endstufe B leitend und übernimmt einen Teil des Stroms bzw. der Abschaltenergie. Aufgrund des toleranzbedingten Unterschieds insbesondere der Zenerspannungen wird Endstufe B nicht die gleiche Energie aufnehmen wie Endstufe A und erwärmt sich daher beispielsweise auch weniger. Je stärker die Temperaturabhängigkeit der Rückkopplung, desto geringer ist die Differenz zwischen den Energien, die von Endstufe A bzw. B übernommen wird.

Diese allgemeine Kompensation ermöglicht es, die individuelle Rückkopplung von Einzelendstufen mit einem stärkeren Temperaturverhalten auszustatten und somit eine gleichmäßigere Verteilung der Energie, insbesondere der beim Abschalten von Induktivitäten auftretenden Abschaltenergie in der Klammerphase auf alle parallel geschalteten Endstufen zu erzielen, ohne die Spezifikation von Anforderungen nach einer geringen Temperaturdrift der Klammerspannung zu verletzen.

## Patentansprüche

1. Endstufe, insbesondere Schalt-Endstufe (10) zum Schalten induktiver oder ohmschinduktiver Lasten (4), umfassend mehrere parallel geschaltete Einzel-Endstufen (A, B) mit wenigstens einer Komponente (2a, 2b) mit beliebiger Zenerspannung, die die Zenerspannung (U_{z}) der Einzel-Endstufe bestimmt und einem Transistor, insbesondere einem Schalttransistor (1), wobei die Komponente (2a, 2b) im oder nahe am Schalttransistor (1) angeordnet sind, so dass sie thermisch mit dem Transistor (1) gekoppelt ist, **dadurch gekennzeichnet, dass** eine weitere Komponente (15a, 15b) mit vorgebbarem Temperaturverhalten entfernt und insbesondere thermisch entkoppelt angeordnet ist.

2. Schalt-Endstufe (10) nach Anspruch 1, **dadurch gekennzeichnet, dass** mehrere parallel geschaltete, gegengekoppelte Transistoren (1a, 1b), in deren Gegenkopplungspfad jeweils ein Bauelement (2a, 2b) mit positivem Temperaturkoeffizient vorhanden ist, das die Klammer- oder Zenerspannung (U_{z}) der Einzel-Enstufen (A, B) bestimmt

3. Schalt-Endstufe (10) nach einem der vorhergehenden Ansprüche, **dadurch gekennzeichnet, dass** die Bauelemente (15a, 15b) als Zenerdioden oder als thermische Widerstände, insbesondere NTC-Widerstände realisiert sind und negative Temperaturkoeffizienten aufweisen.

4. Schalt-Endstufe (10) nach einem der vorhergehenden Ansprüche, **dadurch gekennzeichnet, dass** die Werte der Temperaturkoeffizienten unterschiedlich sind.

5. Schalt-Endstufe (10) nach einem der vorhergehenden Ansprüche, **dadurch gekennzeichnet, dass** die durch die Bauelemente (2a, 2b) und die Bauelemente (15a, 15b) bewirkte Rückkopplung auf die Einzelendstufen unterschiedlich sind.

6. Schalt-Endstufe (10) nach einem der vorhergehenden Ansprüche, **dadurch gekennzeichnet, dass** die gesamte Anordnung in einem Chip intergriert ist.

7. Schalt-Endstufe (10) nach einem der vorhergehenden Ansprüche, **dadurch gekennzeichnet, dass** die Komponenten (2a, 2b) so auf dem Chip angeordnet sind, dass sie eine schnelle Temperaturkompensation ermöglichen und die Komponenten (15a, 15b) so auf dem Chip angeordnet sind, dass sie eine langsame Temperaturkompensation ermöglichen.

8. Schalt-Endstufe (10) nach einem der vorhergehenden Ansprüche, **dadurch gekennzeichnet, dass** die mehreren parallel geschaltete Einzel-Endstufen unterschiedlichen Stromklassen angehören.

9. Schalt-Endstufe (10) nach einem der vorhergehenden Ansprüche, **dadurch gekennzeichnet, dass** die Endstufen-Zenerspannung symmetriert wird, wobei die Zenerspannung der Einzel-Endstufen unter Last und/oder Temperatur höher wird.

10. Verfahren zum Betreiben einer Schalt-Endstufe (10) nach einem der vorhergehenden Ansprüche, **dadurch gekennzeichnet, dass** die beim Abschalten abzubauende Abschaltenergie möglichst gleichmässig auf mehrere Einzel-Endstufen verteilt wird.

11. Verfahren zum Betreiben einer Schalt-Endstufe (10) nach einem der vorhergehenden Ansprüche, **dadurch gekennzeichnet, dass** ein Driften der Klammerspannung aller Einzel-Endstufen (A, B) über eine allgemeine Temperaturveränderung des zugehörigen Chips kompensiert oder überkompensiert wird.

## Claims

1. Output stage, in particular switching output stage (10) for switching inductive or resistive-inductive loads (4), comprising a plurality of parallel-connected individual output stages (A, B) having at least one component (2a, 2b) with any desired zener voltage, which determines the zener voltage (UZ) of the individual output stage, and having a transistor, in particular a switching transistor (1), the component (2a, 2b) being arranged in or close to the switching transistor (1) such that it is thermally coupled to the transistor (1), **characterized in that** a further component (15a, 15b) with a predefinable thermal behaviour is arranged such that it is remote and, in particular, thermally decoupled.

2. Switching output stage (10) according to Claim 1, **characterized in that** a plurality of parallel-connected negative feedback transistors (1a, 1b) are provided, the feedback path of which contains a respective component (2a, 2b) with a positive temperature coefficient, which component determines the clamp or zener voltage (UZ) of the individual output stages (A, B).

3. Switching output stage (10) according to one of the preceding claims, **characterized in that** the components (15a, 15b) are in the form of zener diodes or thermal resistors, in particular NTC resistors, and have negative temperature coefficients.

4. Switching output stage (10) according to one of the preceding claims, **characterized in that** the values of the temperature coefficients are different.

5. Switching output stage (10) according to one of the preceding claims, **characterized in that** the feedback to the individual output stages which is effected by the components (2a, 2b) and that which is effected by the components (15a, 15b) are different.

6. Switching output stage (10) according to one of the preceding claims, **characterized in that** the entire arrangement is integrated in a chip.

7. Switching output stage (10) according to one of the preceding claims, **characterized in that** the components (2a, 2b) are arranged on the chip in such a manner that they enable rapid temperature compensation, and the components (15a, 15b) are arranged on the chip in such a manner that they enable slow temperature compensation.

8. Switching output stage (10) according to one of the preceding claims, **characterized in that** the plurality of parallel-connected individual output stages belong to different current classes.

9. Switching output stage (10) according to one of the preceding claims, **characterized in that** the output stage zener voltage is balanced, the zener voltage of the individual output stages becoming higher under load and/or temperature.

10. Method for operating a switching output stage (10) according to one of the preceding claims, **characterized in that** the turn-off energy to be removed during the turning-off operation is distributed to a plurality of individual output stages as uniformly as possible.

11. Method for operating a switching output stage (10) according to one of the preceding claims, **characterized in that** drifting of the clamp voltage of all individual output stages (A, B) is compensated for or overcompensated by means of a general change in the temperature of the associated chip.

## Revendications

1. Etage final, en particulier étage final de commutation (10) qui permet de commuter des charges (4) inductives ou ohmique-inductives, et comprenant plusieurs étages finaux distincts (A, B) raccordés en parallèle et au moins un composant (2a, 2b) à tension Zener quelconque qui définit la tension Zener (U_{z}) des différents étages finaux et un transistor, en particulier un transistor de commutation (1),
les composants (2a, 2b) étant disposés dans le transistor de commutation (1) ou à proximité de ce dernier de manière à être couplés thermiquement avec le transistor (1),
**caractérisé en ce que**
un autre composant (15a, 15b) dont le comportement en température est prédéterminé est disposé à distance et est en particulier découplé thermiquement.

2. Etage final de commutation (10) selon la revendication 1, **caractérisé en ce qu'**il présente plusieurs transistors (1a, 1b) qui sont raccordés en parallèle et couplés en opposition, avec un composant (2a, 2b) à coefficient positif de température dans chacun des parcours de contre-couplage et qui déterminent la tension de réaction ou Zener (U_{z}) des différents étages terminaux (A, B).

3. Etage final de commutation (10) selon l'une des revendications précédentes, **caractérisé en ce que** les composants (15a, 15b) sont configurés comme diodes Zener ou comme résistances thermiques et en particulier comme résistances NTC et présentent un coefficient de température négatif.

4. Etage final de commutation (10) selon l'une des revendications précédentes, **caractérisé en ce que** les coefficients de température ont des valeurs différentes.

5. Etage final de commutation (10) selon l'une des revendications précédentes, **caractérisé en ce que** les rétroactions réalisées par les composants (2a, 2b) et les composants (15a, 15b) sont différentes sur les différents étages terminaux.

6. Etage final de commutation (10) selon l'une des revendications précédentes, **caractérisé en ce que** l'ensemble de l'agencement est intégré dans une puce.

7. Etage final de commutation (10) selon l'une des revendications précédentes, **caractérisé en ce que** les composants (2a, 2b) sont disposés sur la puce de manière à permettre une compensation rapide de la température et **en ce que** les composants (15a, 15b) sont disposés sur la puce de manière à permettre une compensation lente de la température.

8. Etage final de commutation (10) selon l'une des revendications précédentes, **caractérisé en ce que** les différents étages terminaux raccordés en parallèle appartiennent à différentes classes de courant.

9. Etage final de commutation (10) selon l'une des revendications précédentes, **caractérisé en ce que** les tensions Zener des étages terminaux sont symétrisées, la tension Zener des différents étages terminaux étant différente en charge et/ou en température.

10. Procédé de gestion d'un étage terminal de commutation (10) selon l'une des revendications précédentes, **caractérisé en ce que** l'énergie de débranchement qui est dégagée lors du débranchement est répartie de la manière la plus uniforme possible sur différents étages terminaux.

11. Procédé de gestion d'un étage terminal de commutation (10) selon l'une des revendications précédentes, **caractérisé en ce que** la dérive de la tension d'accrochage de tous les différents étages terminaux (A, B) est compensée ou surcompensée par une modification globale de la température de la puce associée.
